# EUROPÄISCHE PATENTSCHRIFT

(11) **EP 0 644 643 B1**
(45) Veröffentlichungstag und Bekanntmachung des Hinweises auf die Patenterteilung: **21.04.1999**
(21) Anmeldenummer: 94112706.0
(22) Anmeldetag: 13.08.1994
(51) Int. Cl.: H02J 13/00, B60Q 1/00, G05F 1/573, H02J 1/06

(54) **Vorrichtung zur Ansteuerung eines Verbrauchers**
Arrangement for driving an electrical consumer
Dispositif de commande d'une charge électrique

(30) Priorität: 21.09.1993 DE 4331950
(43) Veröffentlichungstag der Anmeldung: 22.03.1995
(73) Patentinhaber: ROBERT BOSCH GMBH, 70442 Stuttgart (DE)
(72) Erfinder: Häfele, Klaus, Ing., D-71397 Leutenbach (DE); Dittmar, Christian, Dipl.-Ing., D-70825 Korntal-Münchingen (DE)

(56) Entgegenhaltungen:
- EP-A- 0 377 853
- EP-A- 0 485 119
- FR-A- 2 458 813

## Beschreibung

Eine solche Vorrichtung zur Ansteuerung eines Verbrauchers, insbesondere einer Warnlampe in einem Kraftfahrzeug, umfaßt im wesentlichen eine Reihenschaltung bestehend aus dem Verbraucher und einem ersten Schaltmittel. Dieses Schaltmittel wird geschlossen und damit der Verbraucher mit Versorgungsspannung beaufschlagt, wenn in einem Steuergerät bzw. einer zugeordneten Einheit ein Fehler auftritt.

Diese Warnlampe muß auch bei Ausfall der Energieversorgung des zugeordneten Steuergerätes sowie einer Unterbrechung der Verbindung zwischen Steuergerät und Warnlampe leuchten. Desweiteren muß verhindert werden, daß bei einem Kurzschluß die Vorrichtung, insbesondere die Warnlampe beschädigt wird.

Die Erfindung betrifft ein Verfahren zur Ansteuerung einer Warneinrichtung zur Anzeige eines Fehlerzustandes eines Steuergeräts in einem Kraftfahrzeug.

Aus der EP 037 7853 ist eine Signallampe eines Generators bekannt. Die beschriebene Schaltung ist derart ausgebildet, daß die Lampe leuchtet, wenn der Generator beim Start noch nicht die übliche Spannung liefert. Ferner leuchtet die Lampe, wenn die vom Generator gelieferte Spannung einen Schwellwert überschreitet. Hierzu ist vorgesehen, daß ein Anschluß der Lampe mit der Batterie und ein Anschluß über ein Schaltmittel mit Masse verbunden ist. Die Lampe leuchtet, wenn die Erregerwicklung des Generators nicht bestromt ist. Dies ist beim Start der Fall und wenn eine Überwachungseinrichtung erkennt, daß die vom Generator erzeugte Spannung größer als ein Schwellwert ist. Übersteigt die Spannung den Schwellwert, so wird ein Schaltmittel angesteuert, dies bewirkt, daß die Erregerwicklung mit Masse verbunden wird. Dies hat den Nebeneffekt, daß auch die Lampe leuchtet. Dieser Zustand bleibt erhalten, bis das Fahrzeug abgestellt und neu gestartet wird. Hierzu dient eine Halteschaltung.

Aus FR-A-2 458 813 ist eine Vorrichtung mit den Merkmalen des Oberbegriffs des Anspruchs 1 bekannt.

Die EP 485 119 zeigt eine Schaltung zur Betreibung einer induktiven Last. Diese ist so ausgebildet, daß der Stromfluß durch die Last unterbrochen wird, wenn der Stromfluß einen Schwellwert überschreitet. Diese Einrichtung zeigt lediglich, daß bei einem Kurzschluß die Stromversorgung unterbrochen wird.

### Aufgabe der Erfindung

Der Erfindung liegt die Aufgabe zugrunde, bei einer Vorrichtung zur Ansteuerung eines Verbrauchers der eingangs genannten Art zu gewährleisten, daß der Verbraucher alle Fehler anzeigt.

### Vorteile der Erfindung

Die erfindungsgemäße Vorrichtung hat den Vorteil, daß die Warnlampe auch eine Unterbrechung der Verbindungsleitung zum Steuergerät anzeigt. Desweiteren leuchtet die Warnlampe auch bei abgeschalteter Energieversorgung des zugeordneten Steuergerätes weiter. Bei einer Ausgestaltung führt auch bei abgeschalteter Energieversorgung ein Kurzschluß nicht zur Beschädigung oder zur Zerstörung der Vorrichtung.

### Zeichnung

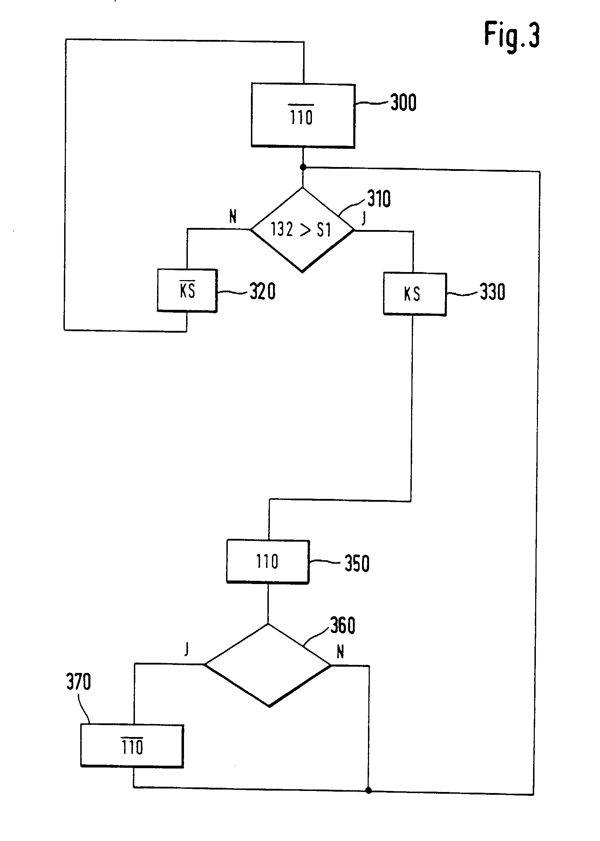

Die Erfindung wird nachstehend anhand der in der Zeichnung dargestellten Ausführungsform erläutert. Es zeigen Figur 1 eine schematische Darstellung der wesentlichsten Elemente der Vorrichtung, Figur 2 verschiedene Signale über der Zeit aufgetragen, Figur 3 ein Flußdiagramm zur Verdeutlichung der Funktionsweise der Vorrichtung und Figur 4 eine weitere Ausführungsform der erfindungsgemäßen Vorrichtung.

### Beschreibung der Ausführungsform

Im folgenden wird die erfindungsgemäße Vorrichtung am Beispiel einer Vorrichtung zur Ansteuerung einer Warnlampe in einem Kraftfahrzeug beschrieben. Diese Warnlampe zeigt an, daß in einem Steuergerät bzw. einer zugeordneten Einheit ein Fehlerzustand aufgetreten ist. Bei dem beschriebenen Ausführungsbeispiel handelt es sich um ein ABS-Steuergerät. Die Warneinrichtung kann aber auch zur Anzeige von Fehlerzuständen in anderen Steuergeräten eingesetzt werden.

Diese Warnlampe wird erfindungsgemäß so angesteuert, daß ein Fehler, insbesondere im Steuergerät, zum Aufleuchten der Warnlampe führt. Die Warnlampe erlischt erst, wenn das Kraftfahrzeug abgeschaltet wird. Um eine Beschädigung der Endstufe, die die Warnlampe ansteuert, zu vermeiden, sollte eine Sicherheitsfunktion insbesondere ein Kurzschlußschutz vorgesehen sein, der auch dann funktionsfähig ist, wenn das Steuergerät abgeschaltet ist.

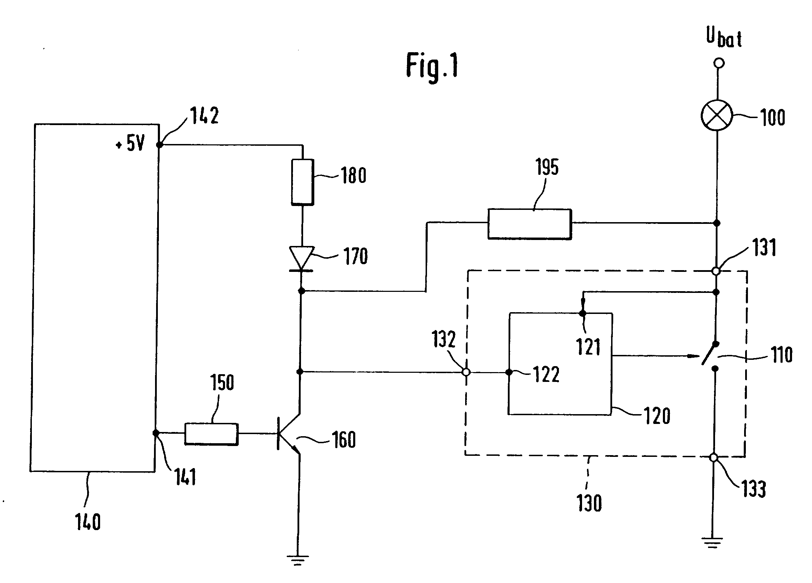

In Figur 1 sind die wesentlichsten Elemente einer ersten Ausführungsform der Schaltungsanordnung aufgezeigt. Ein Verbraucher, der im folgenden als Warneinrichtung bzw. als Warnlampe bezeichnet wird, ist mit 100 bezeichnet. Als Warneinrichtung kann beispielsweise eine Glühlampe oder eine Leuchtdiode eingesetzt werden. Diese Warneinrichtung ist üblicherweise im Bereich des Armaturenbrett angeordnet.

Ein erster Anschluß der Warnlampe steht mit Batteriespannung Ubat in Verbindung. Ein zweiter Anschluß der Warnlampe 100 steht über einen ersten Anschluß 131 mit einem ersten Schaltmittel 130 in Verbindung.

Bei dem ersten Schaltmittel 130 handelt es sich um einen intelligenten Low-Side-Schalter, der wie folgt aufgebaut ist. Der erste Anschluß 131 des ersten Schaltmittels 130 steht über einen Schalter 110 mit dem Masseausgang 133 in Verbindung. Der Masseausgang ist mit Masse verbunden. Der Schalter 110 wird von einer Steuereinheit 120 mit einem Ansteuersignal beaufschlagt. Ein erster Eingang 121 der Steuereinheit 120 ist mit dem ersten Anschluß 131 verbunden. Ein zweiter Eingang 122 der Steuereinheit 120 ist mit einem zweiten Eingang 132 des ersten Schaltmittels 130 verbunden.

Dieser Eingang 132 des ersten Schaltmittels 130 wird auch als Steuereingang bezeichnet.

Ein Steuergerät 140 beaufschlagt über seinen ersten Ausgang 141 sowie einen ohmschen Widerstand 150 einen Transistor 160 mit einem Ansteuersignal. An einem zweiten Ausgang 142 des Steuergerätes 140 liegt ein bestimmter Potentialwert, in diesem Ausführungsbeispiel 5 Volt an. Dieser Ausgang 142 ist über eine Reihenschaltung, die einen ohmschen Widerstand 180 und einer Diode 170 umfaßt, mit dem Eingang 132 des ersten Schaltmittels verbunden. Desweiteren ist der Ausgang 131 des Schaltmittels 130 über die Kollektor-Emitter-Strecke des Transistors 160 mit Masse verbindbar. Ferner ist ein Widerstand 195 vorgesehen, der den Verbindungspunkt zwischen Ausgang der Warnlampe 100 und dem Eingang 131 mit dem Eingang 132 des ersten Schaltmittels verbindet.

Das erste Schaltmittel 130 ist vorzugsweise als integrierte Schaltung realisiert. Der Schalter 110 ist beispielsweise als Transistor insbesondere als Feldeffekttransistor realisiert. Vorzugsweise bilden alle Elemente der Vorrichtung mit Ausnahme der Warnlampe mit dem Steuergerät eine bauliche Einheit. Dies bedeutet, das Steuergerät 140 beinhaltet neben seinen üblichen Elementen zusätzlich die Elemente 130, 150, 160, 170, 180 und 195.

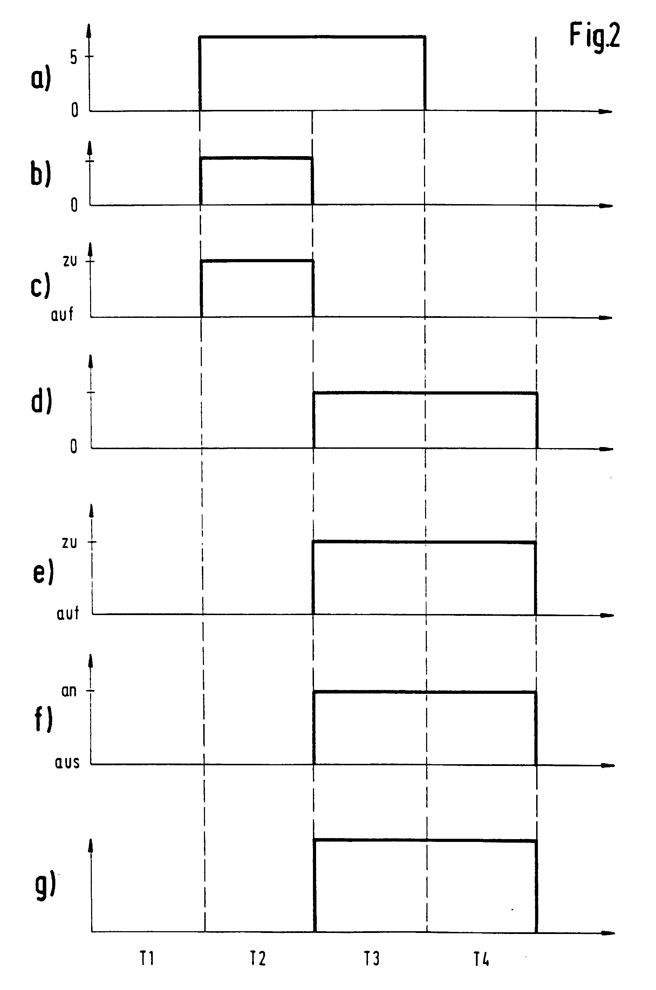

Die Funktionsweise dieser Einrichtung wird nun anhand der Figur 2 erläutert. In Figur 2 sind für unterschiedliche Zeiträume T1, T2, T3 und T4, die verschiedene Betriebszustände wiederspiegeln, verschiedene Signalwerte aufgetragen. In Figur a ist das Signal am Ausgang 142 des Steuergerätes 140 dargestellt. In Figur 2b ist das am Ausgang 141 des Steuergerätes 140 anliegende Signal aufgetragen. Figur 2c zeigt den Schaltzustand des Transistors 160. In Figur 2d ist das Signal am Eingang 132 des ersten Schaltmittels bzw. am Eingang 122 der Steuereinheit 120 aufgetragen. In Figur 2e ist der Schaltzustand des Schalters 110 angegeben. In Figur 2f ist der Betriebszustand der Warnlampe 100 aufgetragen. In Figur 2g ist aufgetragen, ob der Kurzschlußschutz aktiv ist.

Im Zeitraum T1 ist das Steuergerät 140 abgeschaltet. Dieser Zustand liegt vor Inbetriebnahme des Steuergerätes 140 vor. In diesem Zeitraum T1 sind alle Potentialwerte auf Null und alle Schalter geöffnet.

Im Zeitraum T2 arbeitet das Steuergerät 140 im Normalbetrieb. Dies bedeutet, am Ausgang 142 des Steuergerätes 140 liegt eine Spannung von ca. 5 Volt an. Der Ausgang 141 des Steuergerätes 140 befindet sich auf einem High-Pegel. Dies wiederum hat zur Folge, daß der Transistor 160 durchsteuert, das heißt er befindet sich in in seinem geschlossenen oder leitenden Zustand. In diesem Betriebszustand verbindet er den Anschluß 132 bzw. 122 mit Masse. Dies wiederum bedeutet, daß der Schalter 110 in seinem geöffneten Zustand ist.

Solange der Schalter 110 in seinem geöffneten Zustand ist, leuchtet die Warnlampe 100 nicht. Da der Eingang 132 des ersten Schaltmittels 130 sich auf Massepotential befindet, ist der Kurzschlußschutz nicht aktiv. Im Normalbetrieb wird der Transistor vom Steuergerät 140 derart angesteuert, daß der Steuereingang 132 des ersten Schaltmittels mit Masse verbindet. Damit bleibt das Potential am Steuereingang 132 unterhalb einem Wert, der ein Schließen des Schalters 110 bewirken würde.

In Zeitraum T3 erkennt nun das Steuergerät, daß eine Fehlfunktion vorliegt. Diese Fehlfunktion kann sowohl im Steuergerät als auch in der Peripherie vorliegen. Das Steuergerät führt dauernd Tests durch und überprüft, ob das Steuergerät und zugeordnete Bauteile ordnungsgemäß arbeiten. So wird beispielsweise überprüft ob Leitungen unterbrochen sind, Sensoren plausible Signale liefern oder ob das Steuergerät fehlerhafte Signale bereitstellt. Desweiteren werden wichtige Komponenten z.B. Stellglieder und Sensoren überwacht.

Erkennt nun das Steuergerät 140 einen Fehler, so wird über den Ausgang 141 ein Low-Signal ausgegeben. Dieses Low-Signal hat zur Folge, daß der Transistor 160 durch die Ansteuerung und den durch den Widerstand 150 begrenzten Basisstrom abgeschaltet wird. In diesem Fall steht der Eingang 132 des ersten Schaltmittels 130 über den Widerstand 180 und die Diode 170 mit dem Ausgang 142 des Steuergerätes 140 in Verbindung und wird somit mit einer Spannung von ca. 5 Volt beaufschlagt. Dies bewirkt, daß die Steuereinheit 120 ein Signal abgibt, das den Schalter 110 schließt. Dies wiederum hat zur Folge, daß die Warnlampe 100 leuchtet. Gleichzeitig wird auch der Kurzschlußschutz aktiviert.

Auch ein Abfall der Verbindung zwischen Ausgang 141 des Steuergerätes und dem Basisanschluß des Transistors 160 führt dazu, daß der Schalter 110 schließt und die Warnlampe 100 leuchtet.

Der Kurzschlußschutz ist aktiv, solange am Eingang der Steuereinheit 120 eine Spannung ≧ 2,6 Volt anliegt. Dieser Spannungswert von 2,6 Volt ist ein bevorzugter Wert, es können aber auch andere geeignte Spannungswerte gewählt werden.

Wird nun im Zeitraum T4 das Steuergerät abgeschaltet bzw. die Spannungsversorgung zu diesem Steuergerät unterbrochen, so fällt das Signal am Ausgang 142 auf 0 Volt ab. Dies ist beispielsweise der Fall, wenn die Spannungsversorgung für das Steuergerät 140 unterbrochen ist oder das Steuergerät 140 einen sehr schwerwiegenden Fehler erkennt und sich selbst abschaltet. Das Ausgangssignal am Ausgang 141 verbleibt ebenfalls auf 0 Volt. Dies wiederum bedeutet, daß der Transistor 160 weiter unterbrochen bleibt. Der Eingang 132 ist über den Widerstand 195 mit dem zweiten Anschluß der Warnlampe 100 verbunden. Durch geeignete Dimensionierung des Widerstands kann erreicht werden, daß der Eingang in diesem Fall auf einem Potential ≧ 2,6 Volt liegt. Dies bedeutet, der Schalter 110 bleibt weiter in seinem geschlossenen Zustand, die Warnlampe 100 leuchtet und der Kurzschlußschutz ist weiterhin aktiv.

Bei einer Unterbrechung der Steuergeräteversorgungsspannung fließt ein Strom über den Widerstand 195 an den Anschluß 132 des ersten Schaltmittels 130. Der Widerstand 195 und das Schaltmittel 130 sind so zu dimenionieren, daß sich bei geschlossenem Schaltmittel 110 am Eingang 132 eine Spannung ≧ 2,6 Volt einstellt.

Der Widerstand 195 bewirkt also eine Selbsthalteschaltung. Um zu verhindern, daß bei ausgeschaltetem Steuergerät 140 der Strom, der durch den Widerstand 195 fließt, in andere Schaltungsteile wegfließt, ist die Diode 170 vorgesehen. Die Diode 170 und der Transistor 160 verhindern, daß bei ausgeschaltetem Steuergerät, der durch den Widerstand 195 fließende Strom, in andere Schaltungsteile insbesondere in das Steuergerät 140 fließt.

Durch den Widerstand 195 ist ein Selbsthaltemittel realisiert, dies bedeutet, daß sowohl die Warnlampe 100 weiterhin leuchtet also auch daß der Kurzschlußschutz weiter aktiv ist. Dieser ist immer dann aktiv, wenn an dem Eingang 132 eine Spannung ≥ 2,6 Volt anliegt.

Der Widerstand 195 bewirkt, daß am Eingang 132 ständig eine Spannung ≥ 2,6 Volt anliegt, und die Warnlampe leuchtet. Lediglich solange das Steuergerät 140 ordnungsgemäß arbeitet und an seinem Ausgang 141 ein entsprechender Potentialwert anliegt, wird der Transistor 160 durchgesteuert und der Eingang 132 liegt auf Masse. In diesem Fall und bei abgeschalteter Einrichtung, dies bedeutet U_{bat} ist Null, leuchtet die Warnlampe nicht.

Bei der erfindungsgemäßen Einrichtung benötigt das Schaltmittel 130 keine seperate Spannungsversorgung. Durch die Selbstleitung über den Widerstand 195 wird der Eingang 132, auch bei abgeschaltetem oder defektem Steuergerät 140, mit einer spannunq ≥ 2,6 Volt beaufschlagt, und damit der Kurzschlußschutz gewährleistet. Zur Aufrechterhaltung des Kurzschlußschutzes in allen möglichen Betriebszuständen ist keine seperate Spannungsversorgung erforderlich.

Im folgenden wird die Funktionsweise des ersten Schaltmittel, das vorzugsweise als integrierter, intelligenter Low-Side-Schalter realisiert ist, beschrieben. Zu Beginn ist der Schalter 110 geöffnet. Dies wird im Block 300 durch einen Querstrich gekennzeichnet. Anschließend überprüft eine Abfrage 310, ob am Eingang 132 ein Potential anliegt, das über einem ersten Schwellwert S1 liegt. Dieser Schwellwert S1 liegt bei ca. 2,6 Volt. Ist dies nicht der Fali, so verbleibt der Kurzschlußschutz KS in seinem nicht aktivem Zustand, wie in Block 320 dargestellt. Anschließend folgt Schritt 300, dies bedeutet, der Schalter 110 bleibt weiter geöffnet.

Erkennt die Abfrage 310, daß das Potential am Eingang 132 größer oder gleich dem ersten Schwellwert S1 ist, so wird in Schritt 330 der Kurzschlußschutz aktiviert. Anschließend wird im Schritt 350 der Schalter 110 geschlossen. Dies bewirkt, daß ab diesem Zeitpunkt die Warnlampe 100 leuchtet.

Liegt am Eingang 132 ein bestimmter Signalwert an, so wird der Stromfluß durch den Verbraucher frei gegeben. Dieser bestimmte Signalwert liegt vor, wenn bestimmte Bedingungen gegeben sind. Eine solche Bedingung entspricht beispielsweise einem Defekt im Bereich des Steuergerätes 140. Im Normalbetrieb wird der Transistor 160 so angesteuert, daß der Eingang 132 mit Masse verbunden ist.

Ein aktiver Kurzschlußschutz 330 hat zur Folge, daß eine Abfrage 360 überprüft, ob ein Kurzschluß, daß heißt daß der Eingang 131 direkt mit U_{bat} verbunden ist, vorliegt. In diesem Fall wird der Schalter 110 geöffnet. Eine Kurzschlußüberwachung kann beispielsweise wie folgt realisiert sein. Das Schaltmittel, das vorzugsweise als integrierte Schaltung realisiert ist, umfaßt ein Temperatursensor. Übersteigt die Temperatur bzw. die Verlustleistung im Transistor einen bestimmten Wert, so öffnet der Schalter 110. Dies bedeutet die Verlustleistung im Transistor 110 wird durch Taktung des Transistors 110 begrenzt.

Auch bei abgeschaltetem Steuergerät 140 führt ein Kurzschluß des Ausgangs 131 des Schaltmittels 130 nach Batteriespannung U_{bat} zum Öffnen des Schalters. Eine Beschädigung des Schalters kann damit verhindert werden. Nach Aufhebung des Kurzschlusses leuchtet die Warnlampe wieder auf.

Das Ausführungsbeispiel beschreibt die Verhältnisse für eine positive Batteriespannung. Bei negativer Batteriespannung sind die Vorzeichen entsprechend zu vertauschen.

Wesentlich ist, daß das erste Schaltmittel 130 den Stromfluß durch den Verbraucher freigibt, wenn an seinem Steuereingang ein Signal anliegt, das außerhalb eines bestimmten Wertebereichs liegt. Diese Wertebereich liegt bei dem oben beschriebenen Ausführungsbeispiel zwischen Masse und 2,6 Volt. Diese Spannung wird durch das Selbsthaltemittel bereitgestellt. Im Normalbetrieb, wenn kein Fehler vorliegt, wird der Steuereingang mit Masse verbunden, damit das Signal innerhalb des Wertebereichs liegt. In diesem Fall leuchtet die Warneinrichtung nicht. Sobald ein Fehler auftritt nimmt der Steuereingang ein Potential außerhalb des zulässigen Wertebereichs an und die Warneinrichtung leuchtet.

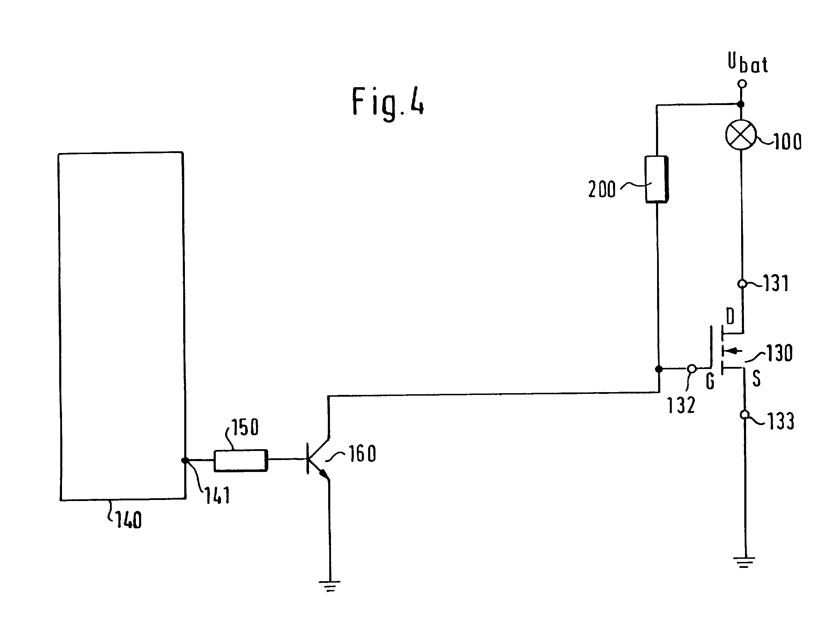

Eine besonders vorteilhafte Ausführungsform der erfindungsgemäßen Vorrichtung ist in Figur 4 dargestellt. Entsprechende Elemente wie in Figur 1 sind mit entsprechenden Bezugszeichen gekennzeichnet.

Das Schaltmittel 130 ist derart ausgestaltet, daß der Stromfluß unterbrochen ist, wenn an seinem Steuereingang kein Ansteuersignal anliegt. Vorzugsweise wird als Schaltmittel 130 ein N-Kanal-Enhancement-MOSFET verwendet. Dabei ist der Drain-Anschluß D, der dem Eingang 131 entspricht, mit der Warnlampe 100 verbunden. Der Source-Anschluß S, der dem Eingang 133 entspricht, steht mit Masse in Kontakt. Der Gate-Anschluß G, der dem Eingang 132 entspricht, steht zum einen über einen Widerstand 200 mit der Versorgungsspannung U_{bat} und zum anderen über das Schaltmittel 160 mit Masse in Verbindung.

Vorzugsweise ist der Feldeffekttransistor und der Widerstand 200 in unmittelbarer Nähe der Warnlampe 100 angeordnet. So sind diese Elemente vorzugsweise im Bereich des Armaturenbrettes angeordnet. Besonders vorteilhaft ist es wenn diese Elemente und die Warnlampe eine bauliche Einheit bilden.

Der in dieser Ausführungsform verwendete N-Kanal-Enhancement-MOSFET sperrt, wenn der Gate-Anschluß G auf Masse liegt. Er leitet, wenn am Gate-Anschluß G eine positive Spannung anliegt. Solange das Steuergerät 140 ordnungsgemäß arbeitet, befindet sich das Schaltmittel 160 in seinem geschlossenen Zustand und der Gate-Anschluß G wird mit Massepotential bzw. mit 0 Volt beaufschlagt. Dies bedeutet der Feldeffekttransistor 130 sperrt und die Warnleuchte 100 leuchtet nicht.

Tritt ein Fehler im Steuergerät auf, so kann die Warnlampe 100 durch Öffnen des Schaltmittels 160 aktiviert werden. Bei einer Unterbrechung der Masseverbindung des Steuergeräts wird das Schaltmittel 160 nicht mehr betätigt bzw. am Gate-Anschluß G des Schaltmittels 130 liegt kein Massepotential mehr an. Über den Widerstand 200 stellt sich am Gate-Anschluß G die Versorgungsspannung U_{bat} ein. Dies wiederum hat zur Folge, daß der Feldeffekttransistor leitet und die Warnlampe 100 leuchtet.

Im Falle einer Unterbrechung im Kabelbaum bzw. wenn kein Steuergerät 140 angeschlossen ist, befindet sich das Gate ebenfalls auf Versorgungsspannung U_{bat} und die Warnlampe 100 leuchtet. Somit wird dem Fahrer auch eine Unterbrechung der Leitung zwischen Steuergerätt und Warnlampe angezeigt.

Vorteilhaft an dieser Schaltungsanordnung ist, daß in der Nähe der Warnlampe, d.h. im Bereich des Armaturenbrettes des Fahrzeuges lediglich ein N-Kanal-Enhancement-MOSFET und ein ohmscher Widerstand integriert werden muß. Diese Bauteile benötigen sehr wenig Bauraum und sind sehr kostengünstig.

## Patentansprüche

1. Vorrichtung zur Ansteuerung einer Warneinrichtung (100) in einem Kraftfahrzeug, mit einer Reihenschaltung bestehend aus der Warneinrichtung (100) und einem ersten Schaltmittel (130), wobei das erste Schaltmittel (130) den Stromfluß durch die Warneinrichtung (100) freigibt, wenn an einem Steuereingang (132) des ersten Schaltmittels (130) ein Signal anliegt, das außerhalb eines bestimmten Wertebereichs liegt, wobei Selbsthaltemittel (195) vorgesehen sind, die unabhängig von dem Steuergerät (140) an dem Steuereingang (132) des ersten Schaltmittels (130) ein Signal bereitstellen, das außerhalb des bestimmten Wertebereichs liegt wobei das Steuergerät (140) ein zweites Schaltmittel (160) derart ansteuert, daß außerhalb des Fehlerzustandes an dem Steuereingang (132) des ersten Schaltmittels (130) ein Signal anliegt das innerhalb des bestimmten Wertebereichs liegt, daß als erstes Schaltmittel (130) ein Low-Side-Schalter eingesetzt wird, dadurch gekennzeichnet, daß das Steuergerät (140) überprüft, ob ein Fehlerzustand vorliegt und die Vorrichtung den Fehlerzustand anzeigt und daß das erste Schaltmittel (130) eine Sicherheitsfunktion beinhaltet, die nur aktiv ist, wenn an seinem Steuereingang (132) ein Signal anliegt, das den bestimmten Wert übersteigt.

2. Vorrichtung nach Anspruch 1, dadurch gekennzeichnet, daß als erstes Schaltmittel (130), insbesondere ein N-Kanal-Enhancement-MOSFET eingesetzt wird, der den Stromfluß freigibt, wenn die an seinem Gate (132) anliegende Spannung einen bestimmten Wert übersteigt.

3. Vorrichtung nach einem der vorherigen Ansprüche, dadurch gekennzeichnet, daß das erste Schaltmittel einen Kurzschlußschutz als Sicherheitsfunktion beinhaltet und als integrierter Schaltkreis realisiert ist.

4. Vorrichtung nach einem der vorherigen Ansprüche, dadurch gekennzeichnet, daß der Kurzschlußschutz bei einem erkannten Kurzschluß den Stromfluß unterbricht.

5. Vorrichtung nach einem der vorherigen Ansprüche, dadurch gekennzeichnet, daß wenigstens ein, zwischen Warneinrichtung und Steuereingang des ersten Schaltmittels geschalteter, Widerstand oder wenigstens ein, zwischen Versorgungsspannung und Steuereingang des ersten Schaltmittels geschalteter, Widerstand als Selbsthaltemittel dient.

6. Vorrichtung nach einem der vorherigen Ansprüche, dadurch gekennzeichnet, daß das erste Schaltmittel und/oder das Selbsthaltemittel in der Nähe der Warneinrichtung angeordnet ist.

7. Vorrichtung nach einem der vorherigen Ansprüche, dadurch gekennzeichnet, daß der Fehlerzustand vorliegt, wenn im Bereich des Steuergerätes, insbesondere eines ABS-Steuergeräts, ein Fehler auftritt.

8. Vorrichtung nach einem der vorherigen Ansprüche, dadurch gekennzeichnet, daß der Steuereingang über das Selbsthaltemittel ständig mit einem Signal beaufschlagt, das den bestimmten Wert übersteigt, und daß im Normalbetrieb das Steuergerät das zweite Schaltmittel derart ansteuert, daß dieses den Steuereingang mit Masse verbindet.

## Claims

1. Device for driving a warning device (100) in a motor vehicle, having a series circuit comprising the warning device (100) and a first switching means (130), the first switching means (130) enabling the flow of current through the warning device (100) if a signal which lies outside a specific value range is present at a control input (132) of the first switching means (130), self-locking means (195) being provided which make available a signal independently of the control unit (140) at the control input (132) of the first switching means, the control unit (140) driving a second switching means (160) in such a way that, outside the fault state, a signal which lies inside the specific value range is present at the control input (132) of the first switching means (130), in that a low-side switch is used as first switching means (130), characterized in that the control unit (140) checks whether a fault state is present and the device displays the fault state, and in that the first switching means (130) includes a safety function which is active only if a signal which exceeds the specific value is present at its control input (132).

2. Device according to Claim 1, characterized in that an N-channel enhancement MOSFET which enables the flow of current if the voltage present at its gate (132) exceeds a specific value is used as first switching means (130).

3. Device according to one of the preceding claims, characterized in that the first switching means includes a short-circuit protection as safety function and is implemented as an integrated circuit.

4. Device according to one of the preceding claims, characterized in that the short-circuit protection interrupts the flow of current when a short-circuit is detected.

5. Device according to one of the preceding claims, characterized in that at least one resistor which is connected between the warning device and control input of the first switching means, or at least one resistor which is connected between the supply voltage and control input of the first switching means serves as self-locking means.

6. Device according to one of the preceding claims, characterized in that the first switching means and/or the self-locking means are arranged in the vicinity of the warning device.

7. Device according to one of the preceding claims, characterized in that the fault state is present if a fault occurs in the region of the control unit, in particular of an ABS control unit.

8. Device according to one of the preceding claims, characterized in that the control input is continuously supplied, via the self-locking means, with a signal which exceeds the specific value, and in that, in normal operation, the control unit drives the second switching means in such a way that the latter connects the control input to earth.

## Revendications

1. Dispositif pour commander une installation de signalisation (100) dans un véhicule automobile comprenant
• un montage en série formé de l'installation de signalisation (100) et d'un premier moyen de commutation (130),
• le premier moyen de commutation (130) libérant le passage du courant à travers l'installation de signalisation (100) lorsqu'une entrée de commande (132) du premier moyen de commutation (130) reçoit un signal situé en dehors d'une plage de valeurs prédéterminée,
• des moyens d'automaintien (195) étant prévus qui, indépendamment de l'appareil de commande (140), fournissent à l'entrée de commande (132) du premier moyen de commutation (130) un signal situé en dehors de la plage de valeurs prédéterminée,
• le moyen de commande (140) commandant un second moyen de commutation (160) pour qu'en dehors de l'état d'erreur, à l'entrée de commande (132) du premier moyen de commutation (130) on a un signal situé à l'intérieur de la plage de valeurs déterminée, et que comme premier moyen de commutation (130) on a un interrupteur « côté bas »,
caractérisé en ce que
l'appareil de commande (140) vérifie la présence d'un état d'erreur et le dispositif affiche un état d'erreur et en ce que le premier moyen de commutation (130) contient une fonction de sécurité qui est seulement active si son entrée de commande (132) reçoit un signal dépassant la valeur prédéterminée.

2. Dispositif selon la revendication 1,
caractérisé en ce que
le premier moyen de commutation (130) est notamment un transistor MOSFET à canal N à enrichissement qui libère le passage du courant si la tension appliquée à sa grille (132) dépasse une valeur déterminée.

3. Dispositif selon l'une des revendications précédentes,
caractérisé en ce que
le premier moyen de commutation contient une protection de court-circuit comme fonction de sécurité et est réalisé sous la forme d'un circuit intégré.

4. Dispositif selon l'une quelconque des revendications précédentes,
caractérisé en ce que
le moyen de protection de court-circuit coupe le passage du courant lorsqu'un court-circuit est détecté.

5. Dispositif selon l'une quelconque des revendications précédentes,
caractérisé en ce qu'
au moins une résistance, branchée entre l'installation d'avertissement et l'entrée de commande du premier moyen de commutation, ou au moins une résistance branchée entre la tension d'alimentation et l'entrée de commande du premier moyen de commutation, sert de moyen d'automaintien.

6. Dispositif selon l'une quelconque des revendications précédentes,
caractérisé en ce que
le premier moyen de commutation et/ou le moyen d'automaintien sont prévus à proximité de l'installation d'avertissement.

7. Dispositif selon l'une des revendications précédentes,
caractérisé en ce qu'
on a un état d'erreur si au niveau de l'appareil de commande, notamment d'un appareil de commande ABS, se produit une erreur.

8. Dispositif selon l'une des revendications précédentes,
caractérisé en ce que
l'entrée de commande reçoit en permanence un signal par le moyen d'automaintien qui dépasse la valeur prédéterminée en ce qu'en fonctionnement normal, l'appareil de commande agit sur le second moyen de commutation pour que celui-ci relie l'entrée de commande à la masse.
